# EUROPEAN PATENT SPECIFICATION

(11) **EP 2 325 663 B1**
(45) Date of publication and mention of the grant of the patent: **02.01.2013**
(21) Application number: 09176690.7
(22) Date of filing: 20.11.2009
(51) Int. Cl.: G01R 29/18

(54) **Three-phase electricity meter with phase monitoring indicator**
Drehstromzähler mit Phasenüberwachungsindikator
Compteurs triphasé doté d'un indicateur de surveillance de phase

(43) Date of publication of application: 25.05.2011
(73) Proprietor: Itron Metering Solutions UK Ltd, Felixtowe, Suffolk IP11 2ER (GB)
(72) Inventor: Robins, Mark, Ipswich, Suffolk IP5 2DQ (GB); White, Richard, Ipswich, Suffolk IP3 8TS (GB); Field, Anthony, Saxmundham, Suffolk IP17 3PY (GB)
(74) Representative: Howson, Richard G.B.

(56) References cited:
- EP-A2- 0 446 962
- CN-Y- 2 809 656
- DE-C1- 19 713 282
- DE-U1- 29 905 610
- GB-A- 1 483 191
- US-A- 5 039 936
- US-A1- 2005 270 016
- DATABASE WPI Week 200268 Thomson Scientific, London, GB; AN 2002-630704 XP002577823 -& JP 2002 168883 A (HIOKI DENKI KK) 14 June 2002 (2002-06-14)
- DATABASE WPI Week 200674 Thomson Scientific, London, GB; AN 2006-712610 XP002577824 -& JP 2006 258722 A (CHUBU KEIKI KOGYO KK) 28 September 2006 (2006-09-28)
- DATABASE WPI Week 200879 Thomson Scientific, London, GB; AN 2008-N57729 XP002577825 -& CN 201 138 359 Y (LUAN H D) 22 October 2008 (2008-10-22)
- DATABASE WPI Week 199743 Thomson Scientific, London, GB; AN 1997-461060 XP002577826 -& JP 09 211032 A (HIOKI DENKI KK) 15 August 1997 (1997-08-15)

## Description

The present invention relates to three-phase electricity meters, and more especially to the display of information for monitoring the operating conditions of such meters.

In a three-phase system, typically in electric power distribution grids, three circuit conductors carry three alternating currents of the same frequency which reach their instantaneous peak values at different times. Taking one conductor as the reference, the other two currents are delayed in time by one-third and two-thirds of one cycle of the electrical current. In addition, three-phase systems may or may not have a neutral wire.

Electricity meters shall be designed for matching the electrical system configuration. Hence, some meters have been developed for three-phase, four-wire electricity supply (star or wye configuration), other meters have been developed for three-phase, three-wire electricity supply (delta configuration). Some other meters have even been developed for matching with both star and delta configurations.

Whatever the configuration used for the three-phase meter, it is important to carefully monitor the operating conditions of the meter, and more precisely to acquire all relevant phase information to enable accurate diagnosis of wiring faults and supply conditions. Those relevant phase information are typically the following ones:
- For each input or phase, information about the energy flow (forward energy flow, reverse energy flow or no measurable energy flow);
- The phase rotation order of the inputs or phases;
- Indication that all the inputs or at least two inputs among the three phases are in phase with each other;
- Absence or presence of a neutral wire;
- The instantaneous power level being delivered through the meter.

Some phase information is monitored and displayed in JP 2002 168 883, DE 299 05 610 U1 and JP 2006 258 722.

On known electromechanical meters, the instantaneous power level is generally indicated by the speed of rotation of a disk.

On known electronic meters, the instantaneous power is indicated by the rate at which an LED flashes on and off.

Some known meters use a display with separate phase indicators for each input, each phase indicator being controlled to either light on, flash or light off depending on whether the energy flow through the phase is forward, reverse or null, and separate arrow indicators to show phase rotation, flashing to indicate an abnormal phase rotation, e.g. inputs in phase.

Today, existing three-phase meters do not enable to monitor all the above-information, even for those meters provided with a display.

This is mostly due to the fact that there is limited space on a meter display, due to physical and economical constraints. Also, segmented displays such as the types of liquid crystal display commonly used have a limited number of segments, to maximise the contrast ratio and ensure that the display is always readable.

There is thus a need for a three-phase electricity meter that graphically displays the maximum of information relating to the phase conditions to allow an operator to see at first glance whether the operating conditions are correct or not, whilst minimising the amount of display area used and without introducing an excessive number of segments.

To this end, the object of the invention is a three-phase electricity meter as defined in claim 1, with at least three inputs adapted to connect to a three-phase electricity supply, said meter comprising a segment display that provides visual indications of information by selectively activating/deactivating a plurality of segments on said display and activation/deactivation means for selectively activating/deactivating said plurality of segments, characterized in that said plurality of segments are locally arranged in a same area of the display so as to form a single icon for monitoring the phase operating conditions of the meter, said single icon comprising at least :
- A first subset of segments each representative of an energy flow within one of the three inputs, said segments of said first subset being arranged according to a first pattern;
- A second subset of segments representative of the phase rotation, said segments of said second subset being arranged according to a second pattern; wherein said first and second patterns are substantially concentrically arranged with respect to a central point of said area, and in that said activation/deactivation means are adapted to control:
- The switching of each segment of said first subset between three distinct optical states depending whether the energy flow of the corresponding input is a forward energy flow, a reverse energy flow or is not measurable;
- The successive activation/deactivation of each segment or group of segments of the second subset in clockwise or counter-clockwise rotation depending on the sign of the phase rotation, and with a rotation speed depending on the instantaneous power level delivered through said meter.

In one embodiment, the first subset of segments comprises three segments, each including a linear portion, the linear portions of the segments being oriented at 120 degrees relative to each other so as to form a star centred on the central point of said area.

Alternatively or in combination, the first subset of segments may also comprise three segments, each including a linear portion, the linear portions of the segments being mutually arranged so as to form a delta centred on the central point of said area.

For three-phase meter further comprising a neutral input adapted to receive a neutral wire of the three-phase electricity supply, the single icon further comprises advantageously an additional segment for indicating the presence or absence of current flow in said neutral wire, preferably arranged on the central point of said area.

According to another feature, the second subset may comprise three segments, each including two ring portions, said three segments being mutually arranged so that all the ring portions are distributed on a same circle centred on the central point of said area. In this case, two ring portions of a same segment within the second subset are preferably separated by a linear portion of one segment of the first subset.

The three segments of the second subset are preferably successively activated/deactivated when instantaneous power level delivered through said meter corresponds to a lowest possible power level, while pairs of successive segments among the three segments are successively activated/deactivated when instantaneous power level delivered through said meter corresponds to a highest possible power level.

Alternatively, the second subset may comprise six segments, each including one ring portion, said six segments being mutually arranged so that all the ring portions are distributed on a same circle centred on the central point of said area. In this case, the six segments are preferably successively activated/deactivated when instantaneous power level delivered through said meter corresponds to a lowest possible power level, while groups of two to five of successive segments among said six segments are successively activated/deactivated when instantaneous power level delivered through said meter increases.

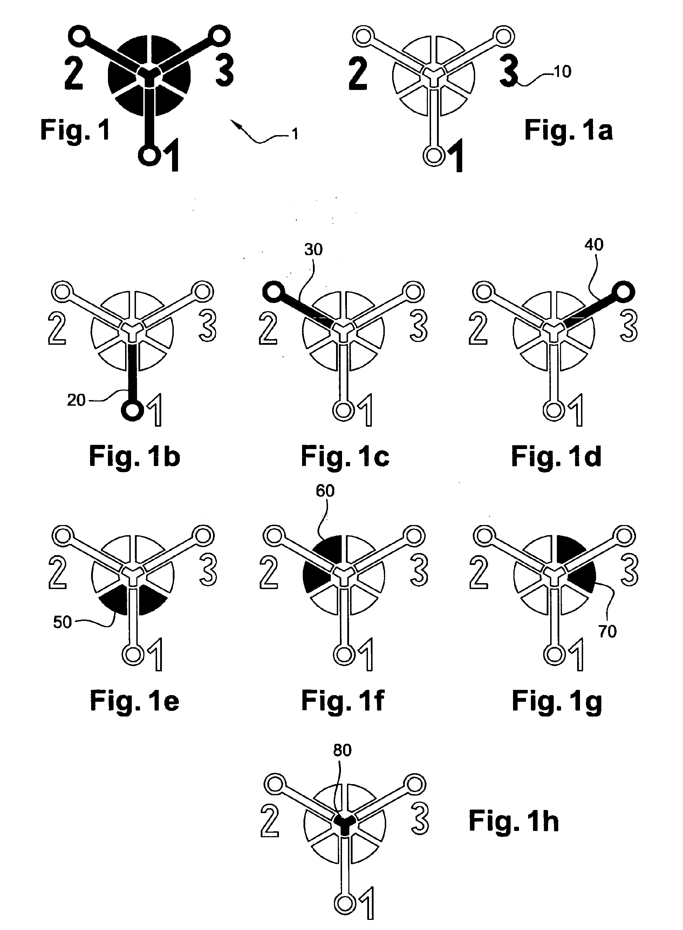

In another embodiment, single icon may further comprise a phase number indicating segment forming a third pattern substantially concentrically arranged with respect to the central point of said area, for simultaneously displaying figures 1, 2 and 3 in the vicinity of corresponding segments of the first pattern.

In another embodiment, second subset comprises three phase number indicating segments, for independently displaying figures 1, 2 and 3 in the vicinity of corresponding segments of the first pattern, and the activation/deactivation means are adapted to control continuously the successive display of the figures in ascending or descending order depending on the sign of the phase rotation, and with a rotation speed depending on the instantaneous power level delivered through said meter.

According to another feature, all the segments of the second subset are simultaneously activated in case the three inputs of the meter are all in phase. In addition, two segments of the second subset may be simultaneously activated in case the corresponding inputs of the meter are in phase, while the remaining segment is flashing displayed.

Additional features of the invention will become apparent by reading the following detailed description of several possible embodiments, made in a connection with the following accompanying drawings:
- Figure 1 shows a first example of an arrangement of segments forming a single icon for monitoring the phase operating conditions of the meter;
- Figures 1a to 1h show separately each segment involved in the constitution of the single icon of figure 1;
- Figure 2 shows a second example of an arrangement of segments forming a single icon for monitoring the phase operating conditions of the meter;
- Figures 2a to 2c show separately some of the segments involved in the constitution of the single icon of figure 2;
- Figure 3 shows a third example of an arrangement of segments forming a single icon for monitoring the phase operating conditions of the meter;
- Figures 3a to 3k show separately each segment involved in the constitution of the single icon of figure 3;
- Figure 4 shows a fourth example of an arrangement of segments forming a single icon for monitoring the phase operating conditions of the meter;
- Figures 4a to 4h show separately each segment involved in the constitution of the single icon of figure 4;
- Figure 5 shows a fifth example of an arrangement of segments forming a single icon for monitoring the phase operating conditions of the meter;
- Figures 5a to 5c show separately some of the segments involved in the constitution of the single icon of figure 5;
- Figure 6 shows a sixth example of an arrangement of segments forming a single icon for monitoring the phase operating conditions of the meter;
- Figures 6a to 6c show separately some of the segments involved in the constitution of the single icon of figure 6;
- Figures 7a and 7b illustrate a schematic of circuitry involved in a three-phase meter for animating an icon, respectively for a star-connected meter and for a delta-connected meter.

With respect first to figures 1 and 1a to 1h, a first embodiment of an animated iconic display enabling a complete and convivial monitoring of the phase operating conditions of a three-phase meter will now be described. We assume in the following discussion that the three-phase meter has three inputs adapted to connect the phases of a three-phase energy supply in a star configuration, and a neutral input adapted to connect the neutral wire of the energy supply.

Figure 1 shows all the segments composing the icon 1 as if all these segments were simultaneously activated, which, as will be seen later, is in fact never the case. Icon 1 occupies advantageously a minimum area of 7 mm square.

Icon 1 comprises a first subset comprising three segments 20, 30, 40, each representative of an energy flow within one of the three inputs. The three segments of the first subset are arranged according to a first pattern which is substantially concentrically arranged with respect to the central point of said area.

As better shown in figures 1b to 1d, each of the three segments 20, 30, 40 includes a linear portion, and the linear portions of the segments are oriented at 120 degrees relative to each other so as to form a star centred on the central point of the area.

Icon 1 also comprises a second subset of three segments 50, 60, 70, representative of the phase rotation. The segments of the second subset are arranged according to a second pattern, which is also substantially concentrically arranged with respect to the central point of the area.

As better shown in figures 1e to 1g, each segment 50, 60, 70 includes two ring portions, and are mutually arranged so that all the ring portions are distributed on a same circle centred on the central point of said area.

In this embodiment, two ring portions of a same segment within said second subset are separated by a linear portion of one segment of said first subset. Hence, linear portion of segment 20 separates the two ring portions of segment 50, linear portion of segment 30 separates the two ring portions of segment 60, and linear portion of segment 40 separates the two ring portion of segment 70.

Single icon 1 further comprises an additional segment 80, shown on figure 1h, for indicating the presence or absence of current flow in a neutral wire connected to the corresponding neutral input of the meter. The additional segment 80 is advantageously located at the central point of the area.

Single icon 1 comprises at last a phase number indicating segment 10 forming a third pattern which is also advantageously concentrically arranged with respect to the central point of said area. This segment 10 is used for simultaneously displaying figures 1, 2 and 3 in the vicinity of corresponding segments 20, 30, 40 of the first pattern.

From the description above, it appears that first, second and third patterns in one hand, and additional segment 80 and phase number indicating segment 10 on the other hand, are all concentrically arranged with respect to the central point of the area, which enables to obtain a global area of optimized size, typically of 7 mm square.

This arrangement, combined with the way the different segments are activated/deactivated for monitoring the phase operating conditions, enables an accurate diagnosis of wiring faults and supply conditions with a optimized number of segments (total of 8 segments), as will now be explained:
As seen above, segments 20, 30, 40 of the first subset are representative of the energy flow within the meter inputs. Hence, each of these segments are advantageously switched between three distinct optical states depending whether the energy flow of the corresponding input is a forward energy flow, a reverse energy flow or is not measurable. The distinct optical states for the switching of segments of said first subset correspond preferably to the display on, the display off and the flashing display for an easy interpretation by an operator.

Three segments 50, 60, 70 of the second subset are representative of the phase rotation. Due to the arrangement of these segments around the central point, successive displays of these segments act as a rotating indicator. More precisely, each of these segments 50, 60, 70 or some groups of segments are continuously successively activated/deactivated either in clockwise or in counter-clockwise rotation depending on the sign of the phase rotation. In addition, the rotation speed to which these segments or groups of segments are successively activated/deactivated depends on the instantaneous power level delivered through said meter.

For instance, the three segments 50, 60, 70 of said second subset are successively activated/deactivated when instantaneous power level delivered through said meter corresponds to the lowest possible power level.

When instantaneous power level delivered through said meter corresponds to a highest possible power level, pairs of successive segments among the three segments 50, 60, 70 are successively activated/deactivated.

Segments 50, 60, 70 are also used for indicating abnormal situations such as three meter inputs in phase, or two over three meter inputs in phase. To this end, all the segments 50, 60, 70 of the second subset are simultaneously activated in case the three inputs of the meter are in phase. Additionally, two segments of said second subset are simultaneously activated in case the corresponding inputs of the meter are in phase, while the remaining segment is flashing displayed.

The way the different segments of icon 1 may be controlled is summarized in the following Array 1:

**Array 1**

| | **Display meaning** | **Segments lit / unlit / flashing** |
|---|---|---|
| | Segments always lit | Segment 10 |
| Phase 1 Flow Monitoring | Forward energy flow | Segment 20 lit |
| | Reverse energy flow | Segment 20 flashing |
| | No measurable energy flow | Segment 20 unlit |
| Phase 2 Flow Monitoring | Forward energy flow | Segment 30 lit |
| | Reverse energy flow | Segment 30 flashing |
| | No measurable energy flow | Segment 30 unlit |
| Phase 3 Flow Monitoring | Forward energy flow | Segment 40 lit |
| | Reverse energy flow | Segment 40 flashing |
| | No measurable energy flow | Segment 40 unlit |
| Phase rotation | Normal phase rotation | The following segments lit successively in sequence: - 50, 60, 70 continuously repeated to indicate rotation with lowest instantaneous power; or - 50+60, 60+70, 70+50 continuously repeated to indicate rotation with higher instantaneous power, - and the speed of rotation increased as instantaneous power increases |
| | Reverse phase rotation | As above, but the segment illuminated in reverse sequence |
| Abnormal situations | All inputs in phase | Segments 50, 60, 70 permanently lit |
| | Two inputs in phase, third input out of phase | Two of the following segments permanently lit: 50, 60, 70. The other, corresponding to the input out of phase flashing |
| Neutral monitoring | Neutral present | Segment 80 lit |
| | Neutral not present | Segment 80 unlit |

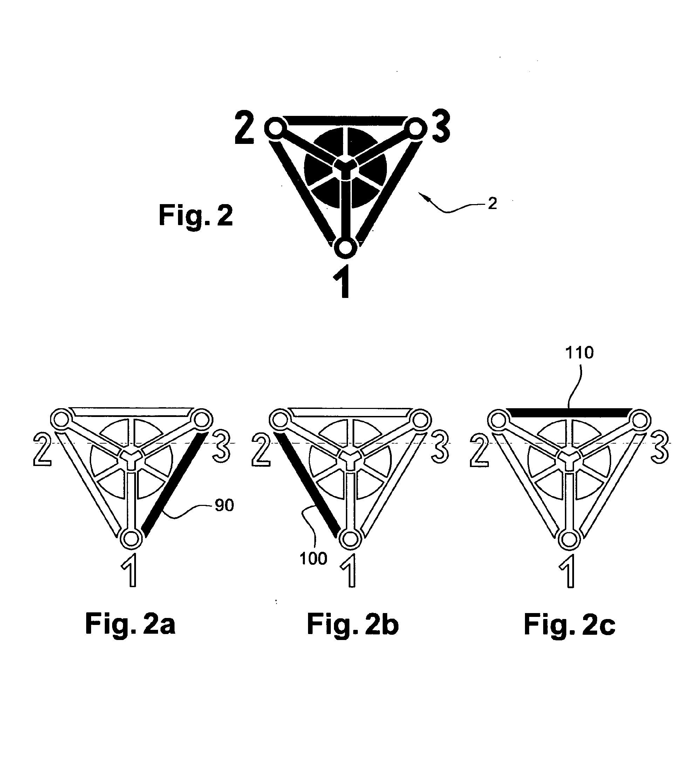

Turning now to figures 2 and 2a to 2c, a second embodiment of an animated iconic display enabling a complete and convivial monitoring of the phase operating conditions of a three-phase meter will now be described. Here, the three-phase meter is adapted not only for a three-phase, four-configuration (star or wye configuration), but also for a three-phase, three-wire configuration (delta configuration).

Icon 2 shown on figure 2 comprises all the segments already disclosed for icon 1 with respect to figures 1 and 1a to 1h.

First subset of segments used for representing energy flow however includes three additional segments 90, 100 and 110.

As shown on figures 2a to 2c, each segment 90, 100, 110 include a linear portion, and the linear portions of the segments are advantageously mutually arranged so as to form a delta centred on the central point of said area.

Star made of segments 20, 30, 40 (figures 1b-1d) lies within the delta made of segments 90, 100, 110.

When the three-phase meter is used in the star configuration, icon 2 is animated according to the rules summarized in above array 1.

If however, the meter is used in the delta configuration, icon 2 is animated as summarized in following Array 2:

**Array 2**

| | **Display meaning** | **Segments lit / unlit / flashing** |
|---|---|---|
| | Segments always lit | Segment 10 |
| Phase 1 | Forward energy flow | Segment 90 lit |
| Flow | Reverse energy flow | Segment 90 flashing |
| Monitoring | No measurable energy flow | Segment 90 unlit |
| Phase 2 | Forward energy flow | Segment 100 lit |
| Flow | Reverse energy flow | Segment 100 flashing |
| Monitoring | No measurable energy flow | Segment 100 unlit |
| Phase 3 | Forward energy flow | Segment 110 lit |
| Flow | Reverse energy flow | Segment 110 flashing |
| Monitoring | No measurable energy flow | Segment 110 unlit |
| Phase rotation | Normal phase rotation Normal phase rotation | The following segments lit successively in sequence: - 50, 60, 70 continuously repeated to indicate rotation with lowest instantaneous power; or - 50+60, 60+70, 70+50 continuously repeated to indicate rotation with higher instantaneous power, - and the speed of rotation increased as instantaneous power increases |
| | Reverse phase rotation | As above, but the segment illuminated in reverse sequence |
| Abnormal situations | All inputs in phase | Segments 50, 60, 70 permanently lit |
| | Two inputs in phase, third input out of phase | Two of the following segments permanently lit: 50, 60, 70. The other, corresponding to the input out of phase flashing |

Here again, an operator can monitor at first glance the configuration of use of the meter, thanks to the use of shapes (delta and star) which correspond to the standard symbols of the wye or delta configuration, and the phase conditions.

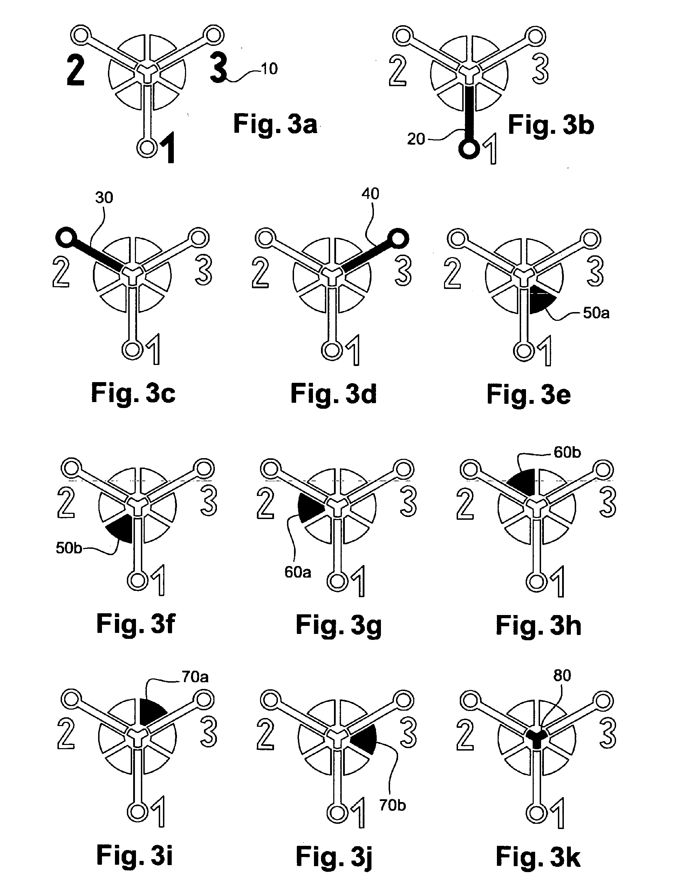

Turning now to figures 3a to 3k, a third embodiment of an animated iconic display enabling a complete and convivial monitoring of the phase operating conditions of a three-phase meter adapted for star configuration will now be described:
Here, the icon has the same constitution than icon 1 of the first embodiment, except concerning the composition of the second subset representative of the phase rotation. Hence, segments 20, 30 and 40 of the first subset shown on figures 3b to 3d correspond to segments already disclosed with respect to figures 1b to 1d, neutral segment 80 shown on figure 3k correspond to segment disclosed with respect to figure 1h, and phase number indicating segment 10 shown on figure 3a corresponds to segment disclosed with respect to figure 1a.

In a different manner however, the second subset representative of the phase rotation comprises here not three, but six segments 50a, 50b, 60a, 60b, 70a, 70b, each including (see figures 3e to 3j) one ring portion, said six segments being mutually arranged so that all the ring portions are distributed on a same circle centred on the central point of said area.

Here again, two linear portions of corresponding two segments of said first subset surround two ring portions of corresponding two segments within said second subset.

This third embodiment require more segments than the first embodiment (eleven segments against 8 segments in the first embodiment), but enables, within the same area of 7 mm square, to provide a smoother indication of rotation.

Indeed, in this embodiment, the six segments 50a, 50b, 60a, 60b, 70a, 70b are advantageously successively activated/deactivated when instantaneous power level delivered through said meter corresponds to a lowest possible power level, while groups of two to five of successive segments among the six segments are successively activated/deactivated when instantaneous power level delivered through said meter increases.

The way the different segments of icon according to this third embodiment may be controlled is summarized in the following Array 3:

**Array 3**

| | **Display meaning** | **Segments lit / unlit / flashing** |
|---|---|---|
| | Segments always lit | Segment 10 |
| Phase 1 | forward energy flow | Segment 20 lit |
| Flow | reverse energy flow | Segment 20 flashing |
| Monitoring | no measurable energy flow | Segment 20 unlit |
| Phase 2 | forward energy flow | Segment 30 lit |
| Flow | reverse energy flow | Segment 30 flashing |
| Monitoring | no measurable energy flow | Segment 30 unlit |
| Phase 3 | forward energy flow | Segment 40 lit |
| Flow | reverse energy flow | Segment 40 flashing |
| Monitoring | no measurable energy flow | Segment 40 unlit |
| Phase rotation | Normal phase rotation | The following segments lit in sequence: - 50a, 50b, 60a, 60b, 70a, 70b to indicate rotation with lowest instantaneous power; or - to indicate the next level adding another segment in the group each time as power increased up to an intermediate level where segments are rotated in groups of five (50a+50b+60a+60b+70a, 50b+60a+60b+70a+70b, 60a+60b+70a+70b+50a, 60b+70a+70b+50a+50b, 70a+70b+50a+50b+60a, 70b+50a+50b+60a+60b), then the speed of rotation increased as instantaneous power increases |
| | Reverse phase rotation | As above, but the segment illuminated in reverse sequence |
| Abnormal situations | All inputs in phase in phase | Segments 50a, 50b, 60a, 60b, 70a, 70b, 80a, 80b permanently lit |
| | Two inputs in phase, third input out of phase input out of phase | Two of the following segments pairs permanently lit: (50a, 50b), (60a, 60b), (70a, 70b). The other, corresponding to the input out of phase flashing |
| Neutral | Neutral present | Segment 80 lit |
| monitoring | Neutral not present | Segment 80 unlit |

Three other embodiments which enable to further optimize the total area of the icon will now be described.

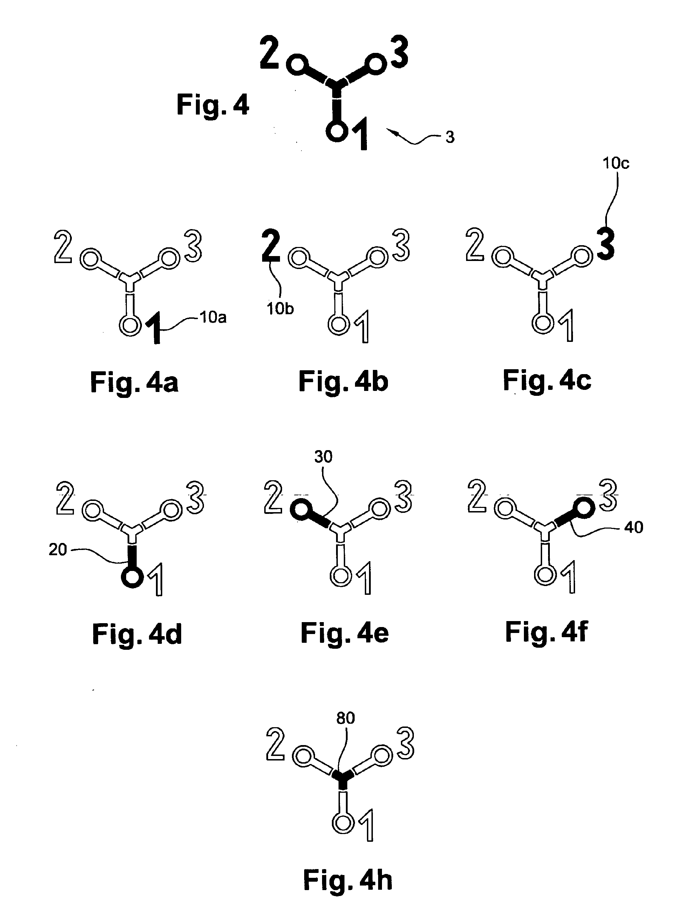

Turning now to figures 4, and 4a to 4k, a fourth embodiment of an animated iconic display enabling a complete and convivial monitoring of the phase operating conditions of a three-phase meter adapted for star configuration will now be described:
Here, icon 3 shown in figure 4 has the same constitution than icon 1 of the first embodiment, as far as the first subset of segments used for monitoring flow energy, and the neutral indicator are concerned.

Hence, segments 20, 30 and 40 of the first subset shown on figures 4e to 4g correspond to segments already disclosed with respect to figures 1b to 1d, neutral segment 80 shown on figure 4h correspond to segment disclosed with respect to figure 1h.

In a different manner however, the second subset representative of the phase rotation comprises three phase number indicating segments 10a, 10b, 10c (see figures 4a to 4c), for independently displaying figures 1, 2 and 3 in the vicinity of corresponding segments 20, 30, 40 of the first pattern.

In this embodiment, the figures are successively displayed in ascending or descending order depending on the sign of the phase rotation, and with a rotation speed depending on the instantaneous power level delivered through said meter.

The way the different segments of icon according to this fourth embodiment may be controlled is summarized in the following Array 4:

**Array 4**

| | **Display meaning** | **Segments lit / unlit flashing** |
|---|---|---|
| | Segments always lit | None |
| Phase 1 | forward energy flow | Segment 20 lit |
| Flow | reverse energy flow | Segment 20 flashing |
| Monitoring | no measurable energy flow | Segment 20 unlit |
| Phase 2 | forward energy flow | Segment 30 lit |
| Flow | reverse energy flow | Segment 30 flashing |
| Monitoring | no measurable energy flow | Segment 30 unlit |
| Phase 3 | forward energy flow | Segment 40 lit |
| Flow | reverse energy flow | Segment 40 flashing |
| Monitoring | no measurable energy flow | Segment 40 unlit |
| Phase rotation | Normal phase rotation | The following segments lit successively in sequence: - 10a, 10b, 10c continuously repeated to indicate rotation - and the speed of rotation increased as instantaneous power increases |
| | Reverse phase rotation | As above, but the segment illuminated in reverse sequence |
| Abnormal situations | All inputs in phase All inputs in phase | Segments 10a, 10b, 10c permanently lit |
| | Two inputs in phase, third input out of phase | Two of the following segments permanently lit: 10a, 10b, 10c. The other, corresponding to the input out of phase flashing |
| Neutral | Neutral present | Segment 80 lit |
| monitoring | Neutral not present | Segment 80 unlit |

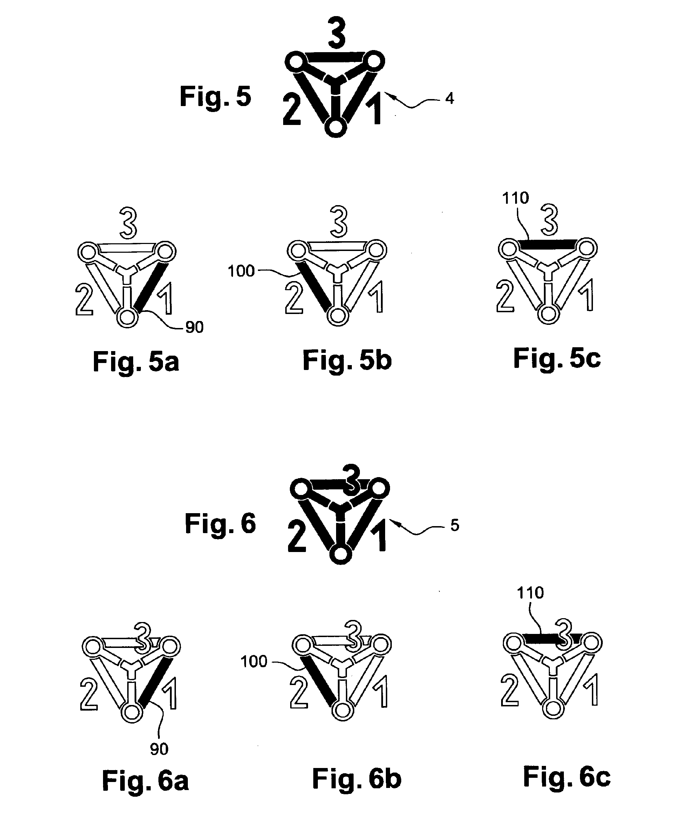

Turning now to figures 5 and 5a to 5c, a fifth embodiment of an animated iconic display enabling a complete and convivial monitoring of the phase operating conditions of a three-phase meter will now be described. Here, the three-phase meter is adapted not only for a three-phase, four-configuration (star or wye configuration), but also for a three-phase, three-wire configuration (delta configuration).

Icon 4 shown on figure 5 comprises all the segments already disclosed for icon 3 with respect to figures 4 and 4a to 4h.

First subset of segments used for representing energy flow however includes three additional segments 90, 100 and 110, shown separately on figures 5a to 5c. Each segment 90, 100, 110 include a linear portion, and the linear portions of the segments are advantageously mutually arranged so as to form a delta centred on the central point of said area. Star made of segments 20, 30, 40 (figures 4e-4g) lies within the delta made of segments 90, 100, 110.

Turning now to figures 6 and 6a to 6c, a sixth embodiment of an animated iconic display enabling a complete and convivial monitoring of the phase operating conditions of a three-phase meter will now be described.

Here again, the three-phase meter is adapted not only for a three-phase, four-configuration (star or wye configuration), but also for a three-phase, three-wire configuration (delta configuration).

Icon 5 shown on figure 6 comprises all the segments already disclosed for icon 4. Segment 110 does not comprise one but two linear portions (see figure 6c), which enables figure 3 to be superimposed between these two linear portions, thus further optimizing the area size. Typically, an area of 5 mm square can be obtained.

Following Array 5 summarizes the animation of icons 4 or 5 when the meter is used in the delta configuration:

**Array 5**

| | **Display meaning** | **Segments lit / unlit flashing** |
|---|---|---|
| | Segments always lit | None |
| Phase 1 | forward energy flow | Segment 90 lit |
| Flow | reverse energy flow | Segment 90 flashing |
| Monitoring | no measurable energy flow | Segment 90 unlit |
| Phase 2 | forward energy flow | Segment 100 lit |
| Flow | reverse energy flow | Segment 100 flashing |
| Monitoring | no measurable energy flow | Segment 100 unlit |
| Phase 3 | forward energy flow | Segment 110 lit |
| Flow | reverse energy flow | Segment 110 flashing |
| Monitoring | no measurable energy flow | Segment 110 unlit |
| Phase rotation | Normal phase rotation | The following segments lit successively in sequence: - 10a, 10b, 10c continuously repeated to indicate rotation - and the speed of rotation increased as instantaneous power increases |
| | Reverse phase rotation | As above, but the segment illuminated in reverse sequence |
| Abnormal situations | All inputs in phase | Segments 10a, 10b, 10c permanently lit |
| | Two inputs in phase, third input out of phase | Two of the following segments permanently lit: 10a, 10b, 10c. The other, corresponding to the input out of phase flashing |
| Neutral | Neutral present | Segment 80 lit |
| monitoring | Neutral not present | Segment 80 unlit |

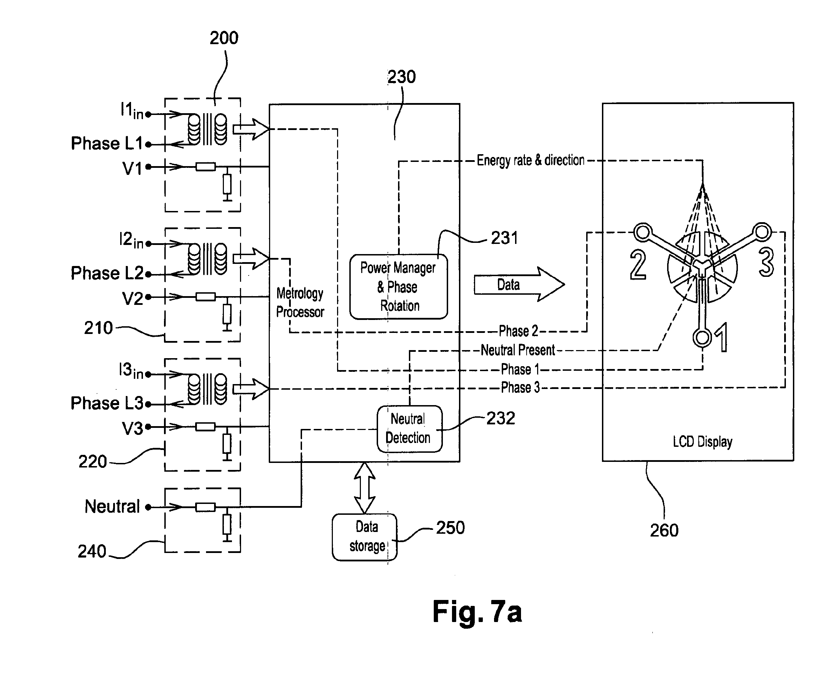

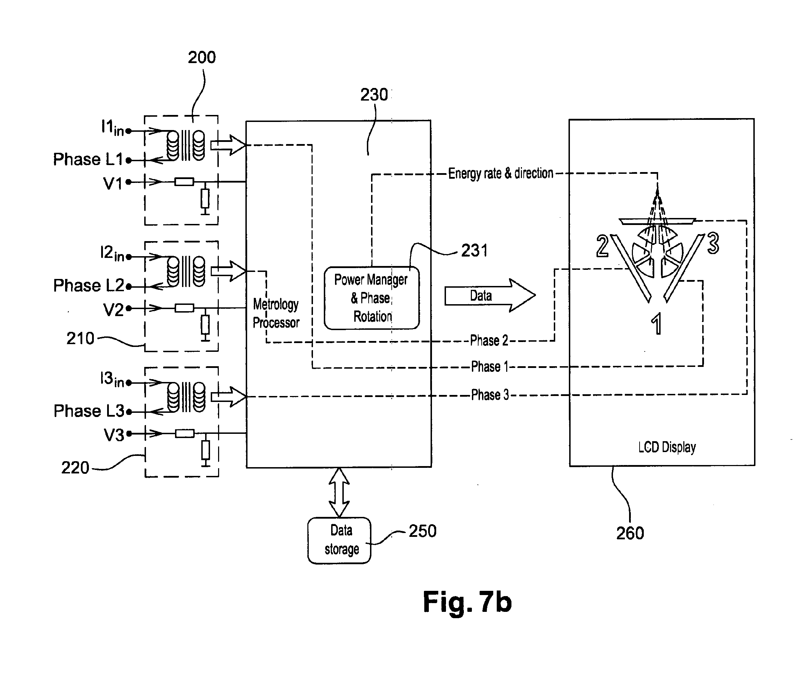

Figure 7a illustrates a schematic of circuitry involved in a three-phase meter for animating the icon of figure 1, while figure 7b illustrates a schematic of circuitry for animating an icon adapted for a delta-connected three-phase meter:
In both figures 7a and 7b, the three-phase meter comprises current and voltage sensors 200, 210, 220 on respective phases L1, L2 and L3 for providing measurements of the current and voltage of each phase to a metrology microprocessor 230 of the meter. In the case of figure 7a, for which the meter has also a neutral input, the circuitry comprises connection means 240 for enabling the detection of the presence or absence of current flow in the neutral. Current and voltage measurements are used by microprocessor 230 for calculating the energy which is delivered to the consumer equipment, and storing the result in data storage means 250. Microcontroller 230 also controls a LCD display 260 for displaying icon used for monitoring the phase operating conditions of the meter. As shown in dotted lines, voltage and current measurements are used for controlling the first subset of segments (star or delta arrangement), while a power manager and phase rotation module 231 of the microprocessor 230 controls the second subset of segment according to the rules summarized in Array 1 (for figure 7a) or Array 2 (for figure 7b). In the case of figure 7a, microprocessor 230 also includes a neutral detection module 232 receiving the output of connecting means 240, and controlling central segment of the icon accordingly.

The invention clearly and effectively displays required phase and power information in a very small area of a meter display, including fault conditions.

The invention is simple to implement on any segmented display.

The invention allows for display sizes to be reduced, giving significant cost savings in an electricity meter design.

## Claims

1. A three-phase electricity meter with at least three inputs adapted to connect to a three-phase electricity supply, said meter comprising a segment display (260) that provides visual indications of information by selectively activating/deactivating a plurality of segments on said display and activation/deactivation means (200-230) for selectively activating/deactivating said plurality of segments, wherein said plurality of segments are locally arranged in a same area of the display so as to form a single icon (1;2;3;4;5) for monitoring the phase operating conditions of the meter, said single icon (1;2;3;4;5) comprising at least :
- A first subset of segments (20, 30, 40, 90, 100, 110) each representative of an energy flow within one of the three inputs, said segments of said first subset being arranged according to a first pattern;
- A second subset of segments (50, 60, 70; 50a, 50b, 60a, 60b, 70a, 70b; 10a, 10b, 10c) representative of the phase rotation, said segments of said second subset being arranged according to a second pattern;
wherein said first and second patterns are substantially concentrically arranged with respect to a central point of said area, and in that said activation/deactivation means (200-230) control :
- The switching of each segment (20, 30, 40, 90, 100, 110) of said first subset between three distinct optical states depending whether the energy flow of the corresponding input is a forward energy flow, a reverse energy flow or is not measurable;
- The successive activation/deactivation of each segment (50, 60, 70; 10a, 10b, 10c) or group of segments (50a, 50b, 60a, 60b, 70a, 70b) of the second subset in clockwise or counter-clockwise rotation depending on the sign of the phase rotation, and with a rotation speed depending on the instantaneous power level delivered through said meter.

2. A three-Phase electricity meter according to claim 1, **characterized in that** said first subset of segments comprises three segments (20, 30, 40), each including a linear portion, the linear portions of the segments being oriented at 120 degrees relative to each other so as to form a star centred on the central point of said area.

3. A three-phase electricity meter according to anyone of the preceding claim, **characterized in that** said first subset of segments comprises three segments (90, 100, 110), each including a linear portion, the linear portions of the segments being mutually arranged so as to form a delta centred on the central point of said area.

4. A three-phase electricity meter according to anyone of the preceding claims, further comprising a neutral input adapted to receive a neutral wire of said three-phase electricity supply, **characterized in that** said single icon further comprises an additional segment (80) for indicating the presence or absence of current flow in said neutral wire.

5. A three-phase electricity meter according to claim 4, **characterized in that** said additional segment (80) is arranged on the central point of said area.

6. A three-phase electricity meter according to anyone of the preceding claims, **characterized in that** said distinct optical states for the switching of segments of said first subset correspond to the display on, the display off and the flashing display.

7. A three-phase electricity meter according to anyone of the preceding claims, **characterized in that** said second subset comprises three segments (50, 60, 70), each including two ring portions, said three segments being mutually arranged so that all the ring portions are distributed on a same circle centred on the central point of said area.

8. A three-phase electricity meter according to a combination of claims 2 and 7, **characterized in that** two ring portions of a same segment within said second subset are separated by a linear portion of one segment of said first subset.

9. A three-phase electricity meter according to anyone of claims 7 or 8, **characterized in that** the three segments (50, 60, 70) of said second subset are successively activated/deactivated when instantaneous power level delivered through said meter corresponds to a lowest possible power level, while pairs (50-60, 60-70, 70-50) of successive segments among the three segments (50, 60, 70) are successively activated/deactivated when instantaneous power level delivered through said meter corresponds to a highest possible power level.

10. A three-phase electricity meter according to anyone of claims 1 to 7, **characterized in that** said second subset comprises six segments (50a, 50b, 60a, 60b, 70a, 70b), each including one ring portion, said six segments being mutually arranged so that all the ring portions are distributed on a same circle centred on the central point of said area.

11. A three-phase electricity meter according to a combination of claims 2 and 10, **characterized in that** two linear portions of corresponding two segments of said first subset surround two ring portions of corresponding two segments within said second subset.

12. A three-phase electricity meter according to anyone of claims 10 or 11, **characterized in that** the six segments (50a, 50b, 60a, 60b, 70a, 70b) are successively activated/deactivated when instantaneous power level delivered through said meter corresponds to a lowest possible power level, while groups of two to five of successive segments among said six segments (50, 60, 70) are successively activated/deactivated when instantaneous power level delivered through said meter increases.

13. A three-phase electricity meter according to anyone of claims 1 to 12, **characterized in that** said single icon (1; 2; 3) further comprises a phase number indicating segment (10) forming a third pattern substantially concentrically arranged with respect to the central point of said area, for simultaneously displaying figures 1, 2 and 3 in the vicinity of corresponding segments of the first pattern.

14. A three-phase meter according to claim 13, **characterized in that** said first, second and third patterns are arranged within an area of 7 mm square.

15. A three-phase, electricity meter according to anyone of claims 1 to 6, **characterized in that** said second subset comprises three phase number indicating segments (10a, 10b, 10c), for independently displaying figures 1, 2 and 3 in the vicinity of corresponding segments of the first pattern, and **in that** said activation/deactivation means (200-230) are adapted to control continuously the successive display of the figures in ascending or descending order depending on the sign of the phase rotation, and with a rotation speed depending on the instantaneous power level delivered through said meter.

16. A three-phase electricity meter according to claim 15, **characterized in that** said first and second patterns are arranged within an area of 5 mm square.

17. A three-phase electricity meter according to anyone of the preceding claims, **characterized in that** all the segments (50, 60, 70; 50a, 50b, 60a, 60b, 70a, 70b; 10a, 10b, 10c) of said second subset are simultaneously activated in case the three inputs of the meter are all in phase.

18. A three-phase electricity meter according to anyone of the preceding claims, **characterized in that** two segments (50, 60, 70; 50a, 50b, 60a, 60b, 70a, 70b; 10a, 10b, 10c) of said second subset are simultaneously activated in case the corresponding inputs of the meter are in phase, while the remaining segment is flashing displayed.

## Patentansprüche

1. Drehstromzähler mit mindestens drei Eingängen, die zum Anschluss an eine Dreiphasen-Stromversorgung ausgelegt sind, wobei der Zähler ein Segment-Display (260) aufweist, das optische Informationsangaben durch selektives Aktivieren/Deaktivieren einer Vielzahl von Segmenten auf dem Display liefert, und Aktivierungs-/Deaktivierungsmittel (200-230) zum selektiven Aktivieren/Deaktivieren der Vielzahl von Segmenten, wobei die Vielzahl von Segmenten lokal in einem gleichen Bereich des Displays angeordnet sind, um einen einzigen Icon (1; 2; 3; 4; 5) zum Überwachen der Phasenbetriebsbedingungen des Zählers zu bilden. wobei der einzige Icon (1: 2; 3; 4; 5) wenigstens aufweist:
eine erste Teilmenge von Segmenten (20, 30, 40, 90, 100, 110), die jeweils für einen Energiefluss in einem der drei Eingänge repräsentativ sind, wobei die Segmente der ersten Teilmenge gemäß einem ersten Muster angeordnet sind;
eine zweite Teilmenge von Segmenten (50, 60, 70; 50a, 50b, 60a, 60b, 70a, 70b; 10a, 10b, 10c), die für die Phasenrotation repräsentativ sind, wobei die Segmente der zweiten Teilmenge gemäß einem zweiten Muster angeordnet sind;
wobei das erste und das zweite Muster im Wesentlichen konzentrisch bezüglich des Mittelpunkts des Bereichs angeordnet sind, und wobei die Aktivierungs-/Deaktivierungsmittel (200-230) steuern:
das Schalten jedes Segments (20, 30, 40, 90, 100, 110) der ersten Teilmenge zwischen drei verschiedenen optischen Zuständen, je nachdem, ob der Energiefluss des entsprechenden Eingangs ein vorwärts gerichteter Energiefluss, ein rückwärts gerichteter Energiefluss oder nicht messbar ist;
die Folgeaktivierung/-deaktivierungjedes Segments (50, 60, 70; 10a, 10b, 10e) oder jeder Gruppe von Segmenten (50a, 50b, 60a, 60b, 70a, 70b) der zweiten Teilmenge in Rotation im oder gegen den Uhrzeigersinn in Abhängigkeit vom Vorzeichen der Phasenrotation, mit einer Rotationsgeschwindigkeit, die von dem durch den Zähler gelieferten momentanen Leistungspegel abhängt.

2. Drehstromzähler nach Anspruch 1, **dadurch gekennzeichnet, dass** die erste Teilmenge von Segmenten drei Segmente (20, 30, 40) aufweist, die jeweils einen linearen Abschnitt aufweisen, wobei die linearen Abschnitte der Segmente unter 120 Grad zueinander ausgerichtet sind, so dass sie einen Stern bilden, der im Mittelpunkt des Bereichs zentriert ist.

3. Drehstromzähler nach einem der vorhergehenden Ansprüche, **dadurch gekennzeichnet, dass** die erste Teilmenge von Segmenten drei Segmente (90, 100, 110) aufweist, die jeweils einen linearen Abschnitt aufweisen, wobei die linearen Abschnitte der Segmente zueinander so angeordnet sind, dass sie ein Delta bilden, das im Mittelpunkt des Bereichs zentriert ist.

4. Drehstromzähler nach einem der vorhergehenden Ansprüche, der des Weiteren einen neutralen Eingang aufweist, welcher ausgelegt ist, um einen neutralen Draht der Dreiphasen-Stromversorgung aufzunehmen, **dadurch gekennzeichnet, dass** der einzige Icon des Weiteren ein zusätzliches Segment (80) zum Anzeigen des Vorhandenseins oder der Abwesenheit von Stromfluss im neutralen Draht aufweist.

5. Drehstromzähler nach Anspruch 4, **dadurch gekennzeichnet, dass** das zusätzliche Segment (80) im Mittelpunkt des Bereichs angeordnet ist.

6. Drehstromzähler nach einem der vorhergehenden Ansprüche, **dadurch gekennzeichnet, dass** die verschiedenen optischen Zustände zum Schalten der Segmente der ersten Teilmenge dem eingeschalteten Display, dem ausgeschalteten Display und dem blinkenden Display entsprechen.

7. Drehstromzähler nach einem der vorhergehenden Ansprüche, **dadurch gekennzeichnet, dass** die zweite Teilmenge drei Segmente (50, 60, 70) aufweist, die jeweils zwei Ringabschnitte aufweisen, wobei die drei Segmente zueinander so angeordnet sind, dass alle Ringabschnitte auf demselben Kreis zentriert im Mittelpunkt des Bereichs verteilt sind.

8. Drehstromzähler nach einer Kombination der Ansprüche 2 und 7, **dadurch gekennzeichnet, dass** zwei Ringabschnitte eines gleichen Segments in der zweiten Teilmenge durch einen linearen Abschnitt eines Segments der ersten Teilmenge getrennt sind.

9. Drehstromzähler nach einem der Ansprüche 7 oder 8, **dadurch gekennzeichnet, dass** die drei Segmente (50, 60, 70) der zweiten Teilmenge nacheinander aktiviert/deaktiviert werden, wenn der durch den Zähler gelieferte momentane Leistungspegel einem niedrigstmöglichen Leistungspegel entspricht, während Paare (50-60, 60-70, 70-50) aufeinander folgender Segmente unter den drei Segmenten (50, 60, 70) der Reihe nach aktiviert/deaktiviert werden, wenn der durch den Zähler gelieferte momentane Leistungspegel einem höchstmöglichen Leistungspegel entspricht.

10. Drehstromzähler nach einem der Ansprüche 1 bis 7, **dadurch gekennzeichnet, dass** die zweite Teilmenge sechs Segmente (50a, 50b, 60a, 60b, 70a, 70b) aufweist, die jeweils einen Ringabschnitt aufweisen, wobei die sechs Segmente zueinander so angeordnet sind, dass alle Ringabschnitte auf demselben Kreis zentriert im Mittelpunkt des Bereichs verteilt sind.

11. Drehstromzähler nach einer Kombination der Ansprüche 2 und 10, **dadurch gekennzeichnet, dass** zwei lineare Abschnitte von zwei entsprechenden Segmenten der ersten Teilmenge zwei Ringabschnitte von zwei entsprechenden Segmenten in der zweiten Teilmenge umgeben.

12. Drehstromzähler nach einem der Ansprüche 10 oder 11, **dadurch gekennzeichnet, dass** die sechs Segmente (50a, 50b, 60a, 60b, 70a, 70b) der Reihe nach aktiviert/deaktiviert werden, wenn der durch den Zähler gelieferte momentane Leistungspegel einem niedrigstmöglichen Leistungspegel entspricht, während Gruppen von zwei bis fünf aufeinander folgenden Segmenten unter den sechs Segmenten (50, 60, 70) der Reihe nach aktiviert/deaktiviert werden, wenn der durch den Zähler gelieferte momentane Leistungspegel steigt.

13. Drehstromzähler nach einem der Ansprüche 1 bis 12, **dadurch gekennzeichnet, dass** der einzige Icon (1; 2; 3) des Weiteren ein Phasennummer-angebendes Segment (10) aufweist, das ein drittes Muster bildet, welches im Wesentlichen konzentrisch bezüglich des Mittelpunkts des Bereichs angeordnet ist, um die Ziffern 1, 2 und 3 in der Nähe entsprechender Segmente des ersten Musters gleichzeitig anzuzeigen.

14. Drehstromzähler nach Anspruch 13, **dadurch gekennzeichnet, dass** das erste, zweite und dritte Muster in einem Bereich von 7 mm² angeordnet sind.

15. Drehstromzähler nach einem der Ansprüche 1 bis 6, **dadurch gekennzeichnet, dass** die zweite Teilmenge drei Phasennummer-angebende Segmente (10a, 10b, 10c) aufweist, um die Ziffern 1, 2 und 3 in der Nähe entsprechender Segmente des ersten Musters unabhängig anzuzeigen, und dass die Aktivierungs-/Deaktivierungsmittel (200-230) ausgelegt sind zum kontinuierlichen Steuern der aufeinander folgenden Anzeige der Ziffern in aufsteigender oder absteigender Reihenfolge in Abhängigkeit vom Vorzeichen der Phasenrotation, und mit einer Rotationsgeschwindigkeit. die von dem durch den Zähler gelieferten momentanen Leistungspegel abhängt.

16. Drehstromzähler nach Anspruch 15, **dadurch gekennzeichnet. dass** das erste und das zweite Muster in einem Bereich von 5 mm² angeordnet sind.

17. Drehstromzähler nach einem der vorhergehenden Ansprüche, **dadurch gekennzeichnet, dass** alle Segmente (50, 60, 70; 50a, 50b, 60a, 60b, 70a, 70b; 10a, 10b, 10c) der zweiten Teilmenge gleichzeitig aktiviert werden, wenn die drei Eingänge des Zählers alle in Phase sind.

18. Drehstromzähler nach einem der vorhergehenden Ansprüche, **dadurch gekennzeichnet, dass** zwei Segmente (50, 60, 70; 50a, 50b, 60a, 60b, 70a, 70b; 10a, 10b, 10c) der zweiten Teilmenge gleichzeitig aktiviert werden, wenn die entsprechenden Eingänge des Zählers in Phase sind, während das verbleibende Segment blinkend angezeigt wird.

## Revendications

1. Compteur électrique triphasé avec au moins trois entrées adaptées pour être reliées à une alimentation en électricité triphasée, ledit compteur comprenant un affichage de segments (260) qui fournit des indications visuelles d'informations en activant et désactivant de manière sélective une pluralité de segments sur ledit affichage et des moyens d'activation et de désactivation (200-230) pour l'activation et la désactivation sélective de ladite pluralité de segments, dans lequel ladite pluralité de segments est localement disposée dans une même zone d'affichage de sorte à former une seule icône (1 ; 2 ; 3 ; 4 ; 5) destinée à surveiller les conditions de fonctionnement de phase du compteur, ladite seule icône (1 ; 2 ; 3 ; 4 ; 5) comprenant au moins :
- un premier sous-ensemble de segments (20, 30, 40, 90, 100, 110) représentant chacun un flux d'énergie dans l'une des trois entrées, lesdits segments dudit premier sous-ensemble étant disposés selon un premier modèle ;
- un second sous-ensemble de segments (50, 60, 70 ; 50a, 50b, 60a, 60b, 70a, 70b ; 10a, 10b, 10c) représentant la rotation de phase, lesdits segments dudit second sous-ensemble étant disposés selon un second modèle ;
dans lequel lesdits premier et second modèles sont disposés sensiblement concentriquement par rapport à un point central de ladite zone et en ce que lesdits moyens d'activation et de désactivation (200-230) commandent :
- la commutation de chaque segment (20, 30, 40, 90, 100, 110) dudit premier sous-ensemble entre trois états visuels distincts selon si le flux d'énergie de l'entrée correspondante est un flux d'énergie aller, un flux d'énergie retour ou n'est pas mesurable ;
- l'activation et la désactivation successives de chaque segment (50, 60, 70 ; 10a, 10b, 10c) ou groupe de segments (50a, 50b, 60a, 60b, 70a, 70b) du second sous-ensemble en rotation dans le sens horaire ou antihoraire selon le signe de la rotation de phase, et à une vitesse de rotation selon le niveau de puissance instantanée fourni par ledit compteur.

2. Compteur électrique triphasé selon la revendication 1, **caractérisé en ce que** ledit premier sous-ensemble de segments comprend trois segments (20, 30, 40), chacun comprenant une partie linéaire, les parties linéaires des segments étant orientées à 120 degrés les unes par rapport aux autres de sorte à former une étoile centrée sur le point central de ladite zone.

3. Compteur électrique triphasé selon l'une quelconque des revendications précédentes, **caractérisé en ce que** ledit premier sous-ensemble de segments comprend trois segments (90, 100, 110), chacun comprenant une partie linéaire, les parties linéaires des segments étant mutuellement disposées de sorte à former un delta centré sur le point central de ladite zone.

4. Compteur électrique triphasé selon l'une quelconque des revendications précédentes, comprenant en outre une entrée neutre adaptée pour recevoir un conducteur neutre de ladite alimentation en électricité triphasée, **caractérisé en ce que** ladite seule icône comprend en outre un segment supplémentaire (80) pour indiquer la présence ou l'absence du flux de courant dans ledit conducteur neutre.

5. Compteur électrique triphasé selon la revendication 4, **caractérisé en ce que** ledit segment supplémentaire (80) est disposé sur le point central de ladite zone.

6. Compteur électrique triphasé selon l'une quelconque des revendications précédentes, **caractérisé en ce que** lesdits états visuels distincts pour la commutation des segments dudit premier sous-ensemble correspondent à l'affichage allumé, l'affichage éteint et l'affichage clignotant.

7. Compteur électrique triphasé selon l'une quelconque des revendications précédentes, **caractérisé en ce que** ledit second sous-ensemble comprend trois segments (50, 60, 70), chacun comprenant deux parties annulaires, lesdits trois segments étant mutuellement disposés de sorte que toutes les parties annulaires soient distribuées sur un même cercle centré sur le point central de ladite zone.

8. Compteur électrique triphasé selon l'une quelconque des revendications 2 et 7, **caractérisé en ce que** deux parties annulaires d'un même segment dans ledit second sous-ensemble sont séparées par une partie linéaire d'un segment dudit premier sous-ensemble.

9. Compteur électrique triphasé selon l'une quelconque des revendications 7 ou 8, **caractérisé en ce que** les trois segments (50, 60, 70) dudit second sous-ensemble sont activés et désactivés de manière successive lorsque le niveau de puissance instantanée fourni par ledit compteur correspond à un niveau de puissance le plus bas possible alors que des paires (50-60, 60-70, 70-50) de segments successifs parmi les trois segments (50, 60, 70) sont activées et désactivées successivement lorsque le niveau de puissance instantanée fourni par ledit compteur correspond à un niveau de puissance le plus haut possible.

10. Compteur électrique triphasé selon l'une quelconque des revendications 1 à 7, **caractérisé en ce que** ledit second sous-ensemble comprend six segments (50a, 50b, 60a, 60b, 70a, 70b), chacun comprenant une partie annulaire, lesdits six segments étant mutuellement disposés de sorte que toutes les parties annulaires soient distribuées sur un même cercle centré sur le point central de ladite zone.

11. Compteur électrique triphasé selon l'une quelconque des revendications 2 et 10, **caractérisé en ce que** deux parties linéaires de deux segments correspondants dudit premier sous-ensemble entourent deux parties annulaires de deux segments correspondants dans ledit second sous-ensemble.

12. Compteur électrique triphasé selon l'une quelconque des revendications 10 ou 11, **caractérisé en ce que** les six segments (50a, 50b, 60a, 60b, 70a, 70b) sont activés et désactivés successivement lorsque le niveau de puissance instantanée fourni par ledit compteur correspond à un niveau de puissance le plus bas possible alors que des groupes de deux à cinq des segments successifs parmi lesdits six segments (50, 60, 70) sont activés et désactivés successivement lorsque le niveau de puissance instantanée fourni par ledit compteur augmente.

13. Compteur électrique triphasé selon l'une quelconque des revendications 1 à 12, **caractérisé en ce que** ladite seule icône (1 ; 2 ; 3) comprend en outre un segment indiquant le nombre de phases (10) formant un troisième modèle disposé sensiblement concentriquement par rapport au point central de ladite zone, pour l'affichage simultané des figures 1, 2 et 3 à proximité des segments correspondants du premier modèle.

14. Compteur électrique triphasé selon la revendication 13, **caractérisé en ce que** ledit premier, deuxième et troisième modèles sont disposés dans une zone de 7 mm².

15. Compteur électrique triphasé selon l'une quelconque des revendications 1 à 6, **caractérisé en ce que** ledit second sous-ensemble comprend trois segments indiquant le nombre de phases (10a, 10b, 10c) pour l'affichage indépendant des figures 1, 2 et 3 à proximité des segments correspondants du premier modèle, et **en ce que** lesdits moyens d'activation et de désactivation (200-230) sont adaptés pour commander en continu l'affichage successif des figures dans l'ordre ascendant ou descendant selon le signe de la rotation de phase et à une vitesse de rotation selon le niveau de puissance instantanée fourni par ledit compteur.

16. Compteur électrique triphasé selon la revendication 15, **caractérisé en ce que** lesdits premier et second modèles sont disposés dans une zone de 5 mm².

17. Compteur électrique triphasé selon l'une quelconque des revendications précédentes, **caractérisé en ce que** tous les segments (50, 60, 70 ; 50a, 50b, 60a, 60b, 70a, 70b ; 10a, 10b, 10c) dudit second sous-ensemble sont simultanément activés au cas où les trois entrées du compteur seraient toutes en phase.

18. Compteur électrique triphasé selon l'une quelconque des revendications précédentes, **caractérisé en ce que** deux segments (50, 60, 70 ; 50a, 50b, 60a, 60b, 70a, 70b ; 10a, 10b, 10c) dudit second sous-ensemble sont simultanément activés au cas où les entrées correspondantes du compteur seraient en phase pendant que le segment restant est affiché clignotant.
